# EUROPEAN PATENT SPECIFICATION

(11) **EP 0 749 127 B1**
(45) Date of publication and mention of the grant of the patent: **26.09.2001**
(21) Application number: 96109241.8
(22) Date of filing: 10.06.1996
(51) Int. Cl.: G11C 11/22

(54) **Data storage element and method for restoring data**
Datenspeicherelement und Datenwiederherstellungsverfahren
Elément d'emmagasinage de données et méthode de restauration de données

(30) Priority: 14.06.1995 US 490368
(43) Date of publication of application: 18.12.1996
(73) Proprietor: MOTOROLA, INC., Schaumburg, IL 60196 (US)
(72) Inventor: Tai, Jy-Der D., Phoenix, Arizona 85048 (US)
(74) Representative: Gibson, Sarah Jane

(56) References cited:
- EP-A- 0 293 798
- EP-A- 0 615 247

## Description

### Background of the Invention

The present invention relates, in general, to data storage elements, and more particularly, to nonvolatile data storage elements.

The packing density and the power consumption of nonvolatile data storage elements are becoming increasingly important issues in low power applications including portable computers and personal communication. Typically, a ferroelectric nonvolatile data storage element includes a capacitor with polarization retention for storing information and a switch, such as a bi-directional pass gate, for accessing the capacitor. When a bi-directional pass gate, e.g., a complementary metal oxide semiconductor (CMOS) pass gate, consisting of an n-channel insulated gate field effect transistor (IGFET) and a p-channel IGFET, is used as a switch to access a ferroelectric memory capacitor, data can be stored and restored without degradation because there is no voltage drop across the pass gate. However, in high density ferroelectric random access memory (FERAM) designs, a pass gate having a single transistor is preferable because it uses less area than a CMOS pass gate.

As those skilled in the art are aware, a high level voltage transmitted through a single n-channel IGFET pass gate is degraded by one transistor threshold voltage, which results in a voltage degradation when storing and restoring a logical "one" in a FERAM cell. Similarly, a low level voltage transmitted through a single p-channel IGFET pass gate is degraded by one transistor threshold voltage, which results in a voltage degradation when storing and restoring a logical "zero" in a FERAM cell. As a result, the memory cell does not operate symmetrically and less charge is extracted from the memory cell during subsequent "read" operations.

One technique for preventing data degradation in a FERAM having a single transistor pass gate is to use a word line booster. In this technique, a word line voltage that is one threshold voltage higher than the supply voltage is applied to the gate terminal of the pass gate transistor. The higher gate voltage prevents the voltage degradation. However, each time the word line is boosted, the memory cell consumes extra power.

Accordingly, it would be advantageous to have an energy efficient, nonvolatile memory cell capable of fully restoring data after a "read" operation. It would be of further advantage for the memory cell to use a single transistor pass gate for high packing density.

### Summary of the Invention

According to one aspect of the present invention, there is provided a data storage element as claimed in claim 1. According to another aspect of the present invention, there is provided a method for restoring data in a data storage element as claimed in claim 4.

### Brief Description of the Drawings

FIG. 1 illustrates a schematic diagram of a memory cell in accordance with an embodiment of the present invention; and
FIG. 2 is a hysteresis loop describing polarization charge as a function of voltage in a ferroelectric capacitor in the memory cell of FIG. 1.

### Detailed Description of the Drawings

Generally, the present invention provides a data storage element such as, for example, a nonvolatile memory cell and a method for accessing data in the data storage element. In accordance with the present invention, the nonvolatile memory cell comprises a switch and a ferroelectric capacitor. In addition, the nonvolatile memory cell of the present invention is coupled for receiving electrical signals through a word line, a plate line, and a bit line. The use of word lines, plate lines, and bit lines in memory devices is more fully described in "An Experimental 512-bit Nonvolatile Memory with Ferroelectric Storage Cell" by Evans and Womack (*IEEE J. Solid-State Circuits,* vol. 23, no. 5, pp. 1171-1175, October 1988). In the present invention, the nonvolatile memory cell fully restores data after a "read" operation without using techniques such as boosting the voltage of the word line. The nonvolatile memory cell of the present invention is energy efficient compared with prior art structures.

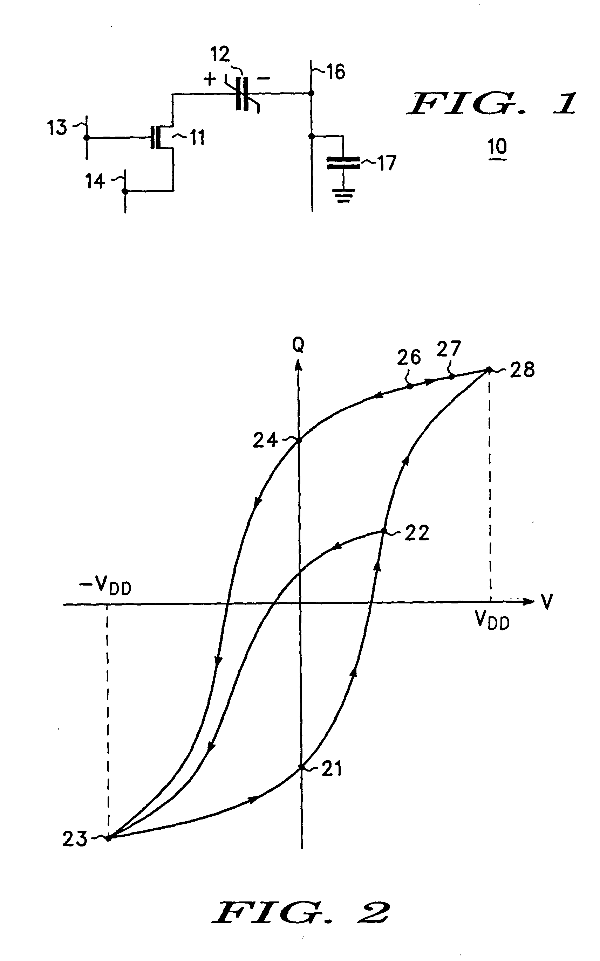

FIG. 1 illustrates a schematic diagram of a memory cell 10 configured in accordance with an embodiment of the present invention. Memory cell 10 includes a switch 11, which has a first current conducting terminal coupled to a bit line 16 via a ferroelectric capacitor 12, a second current conducting terminal connected to a plate line 14, and a control terminal connected to a word line 13. By way of example, switch 11 is an n-channel IGFET, wherein the source terminal serves as the first current conducting terminal, the drain terminal serves as the second current conducting terminal, and the gate terminal serves as the control terminal. Although switch 11 is described as an n-channel insulated gate field effect transistor, it should be understood that this is not a limitation of the present invention. For example, switch 11 may be a p-channel insulated gate field effect transistor, a metal semiconductor field effect transistor, a junction field effect transistor, or the like. In addition, switch 11 may include a plurality of transistors such as, for example, a bipolar transistor pair or a CMOS pass gate. FIG. 1 further includes a bit line capacitor 17 connected to a sense amplifier (not shown). Although memory cell 10 of FIG. 1 is illustrated in a one transistor, one capacitor configuration, this is not intended as a limitation of the present invention. In other words, the memory cell may be, for example, in a two transistor, two capacitor configuration, in which one capacitor stores the data and the other capacitor stores the complementary value of the data. Furthermore, a memory device may be comprised of a single memory cell as shown in FIG. 1, or a plurality of memory cells.

In operation, word line 13 transmits control signals, plate line 14 transmits extraction signals, and bit line 16 transmits data to and from memory cell 10. Data is written into memory cell 10 through the steps of: supplying a bit line voltage in accordance with the data value, turning on switch 11, raising and lowering the plate line voltage to place ferroelectric capacitor into a state determined by the data value, and turning off switch 11 to isolate ferroelectric capacitor 12 from plate line 14, resulting in data being stored in ferroelectric capacitor 12. Data is read from memory cell 10 through the steps of: turning on switch 11, raising the plate line voltage to extract polarization charge from ferroelectric capacitor 12 and transmitting it to bit line capacitor 17, and applying a bit line voltage in accordance with the amount of electric charge in bit line capacitor 17, resulting in data being read from memory cell 10. Data is then restored to memory cell 10 by lowering the plate line voltage, thereby placing ferroelectric capacitor 12 in a state determined by the bit line voltage, and turning off switch 11 to isolate ferroelectric capacitor 12 from plate line 14, resulting in the original data being restored in ferroelectric capacitor 12. Writing, reading, and restoring data in memory cells, such as memory cell 10, will be further described infra.

FIG. 2 is a hysteresis loop describing polarization charge (*Q*) in ferroelectric capacitor 12 as a function of voltage (*V*) across ferroelectric capacitor 12. It should be noted that when the voltage across ferroelectric capacitor 12 is zero, ferroelectric capacitor 12 can be in either of two polarization states, a logical "one" polarization state 21 or a logical "zero" polarization state 24. When performing a "read" operation, a logical value represented by the polarization state of ferroelectric capacitor 12 in memory cell 10 is retrieved and the original polarization state in ferroelectric capacitor 12 is restored. When performing a "write" operation, ferroelectric capacitor 12 is placed in a polarization state according to the logical value to be written into memory cell 10, regardless of the polarization history of ferroelectric capacitor 12.

Performing a "read" operation when ferroelectric capacitor 12 is initially in logical "one" polarization state 21 can be achieved through the following steps. Before a "read" command is executed, word line 13 and plate line 14 are placed at ground voltage level, i.e., word line 13 and plate line 14 are grounded. Therefore, IGFET 11 is non-conductive and ferroelectric capacitor 12 is isolated from plate line 14. The voltage across the plates of ferroelectric capacitor 12 is zero. The reading process is initiated when word line 13 and plate line 14 are raised to, for example, a supply voltage (*V*_{*DD*}), wherein IGFET 11 is turned on and ferroelectric capacitor 12 is coupled to plate line 14 through IGFET 11. The electric field in ferroelectric capacitor 12 created by the high plate line voltage is in the opposite direction from its initial polarization field. The electric field depolarizes ferroelectric capacitor 12. Furthermore, the electric field may polarize ferroelectric capacitor 12 in the opposite direction depending on the capacitance ratio of ferroelectric capacitor 12 to bit line capacitor 17. The polarization charge extracted from ferroelectric capacitor 12 charges bit line capacitor 17 and raises the bit line voltage. IGFET 11 becomes non-conductive when the voltage at the source terminal of IGFET 11 reaches one threshold voltage below *V*_{*DD*}. Ferroelectric capacitor 12 is in an intermediate state 22, as shown in FIG. 2. At this moment, a large amount of electric charge, equal to the difference in the polarization charge between intermediate state 22 and logical "one" polarization state 21, has been extracted from ferroelectric capacitor 12 and placed in bit line capacitor 17, resulting in a high bit line voltage. The sense amplifier which is connected to bit line capacitor 17 is enabled, senses the high bit line voltage, and raises the bit line voltage to *VDD,* resulting in a logical "one" being read from memory cell 10. IGFET 11 becomes conductive by grounding plate line 14. The voltage across ferroelectric capacitor 12 is -*V*_{*DD*} and ferroelectric capacitor 12 is in saturation state 23. Ferroelectric capacitor 12 is isolated from plate line 14 by grounding word line 13, i.e., by turning off IGFET 11. Ferroelectric capacitor 12 changes from saturation state 23 to logical "one" polarization state 21, as shown in FIG. 2, because of the leakage from ferroelectric capacitor 12. Therefore, a logical "one" is restored without degradation. If the reading process is initiated before ferroelectric capacitor 12 completes its transition from saturation state 23 to logical "one" polarization state 21, the electric charge in ferroelectric capacitor 12 contributes positive charge to bit line capacitor 17, resulting in an enhanced bit line voltage.

Performing a "read" operation when ferroelectric capacitor 12 is initially in logical "zero" polarization state 24, can be achieved through the following steps. Before a "read" command is executed, word line 13 and plate line 14 are grounded. Therefore, IGFET 11 is non-conductive and ferroelectric capacitor 12 is isolated from plate line 14. The voltage across the plates of ferroelectric capacitor 12 is zero. The reading process is initiated when word line 13 and plate line 14 are raised to, for example, *V*_{*DD*}, wherein IGFET 11 is turned on and ferroelectric capacitor 12 is coupled to plate line 14 through IGFET 11. The electric field in ferroelectric capacitor 12 created by the high plate line voltage is in the same direction as its initial polarization field. The electric field further polarizes ferroelectric capacitor 12, charges bit line capacitor 17, and raises the bit line voltage. Ferroelectric capacitor 12 moves to an intermediate state 26. At this moment, a small amount of electric charge, equal to the difference in the polarization charge between intermediate state 26 and logical "zero" polarization state 24, has been placed in bit line capacitor 17, resulting in a low bit line voltage. The sense amplifier which is connected to bit line capacitor 17 is enabled, senses the low bit line voltage, and lowers the bit line voltage to ground, resulting in a logical "zero" being read from memory cell 10. IGFET 11 becomes non-conductive when the voltage across ferroelectric capacitor 12 reaches one threshold voltage below *V*_{*DD*}. Ferroelectric capacitor 12 is in a state 27, as shown in FIG. 2. IGFET 11 becomes conductive by grounding plate line 14. The voltage across ferroelectric capacitor 12 is reduced to zero, and ferroelectric capacitor 12 returns to logical "zero" polarization state 24. Ferroelectric capacitor 12 is isolated from plate line 14 by grounding word line 13, i.e., by turning off IGFET 11. In addition, grounding word line 13 maintains ferroelectric capacitor 12 in logical "zero" polarization state 24. Therefore, a logical "zero" is restored without degradation.

Performing a "write" operation to store a logical "one" into memory cell 10 can be achieved through the following steps. Before a "write" command is executed, word line 13 and plate line 14 are grounded. Therefore, IGFET 11 is non-conductive and ferroelectric capacitor 12 is isolated from plate line 14. The writing process is initiated when bit line 16 is raised to, for example, *V*_{*DD*}, which represents logical "one". Word line 13 is raised to, for example, *V*_{*DD*}, resulting in IGFET 11 being turned on and ferroelectric capacitor 12 being coupled to plate line 14 through IGFET 11. The voltage across ferroelectric capacitor 12 *is -V*_{*DD*}. Ferroelectric capacitor 12 changes to saturation state 23, as shown in FIG. 2, regardless of its initial polarization state. Grounding word line 13 turns off IGFET 11 and isolates ferroelectric capacitor 12 from plate line 14. Ferroelectric capacitor 12 changes from saturation state 23 to logical "one" polarization state 21 because of the leakage from ferroelectric capacitor 12. Therefore, a logical "one" is stored without degradation.

Performing a "write" operation to store a logical "zero" into memory cell 10 can be achieved through the following steps. Before a "write" command is executed, word line 13 and plate line 14 are grounded. Therefore, IGFET 11 is non-conductive and ferroelectric capacitor 12 is isolated from plate line 14. The writing process is initiated when bit line 16 is placed at, for example, ground voltage level, which represents logical "zero". Word line 13 is raised to, for example, one threshold voltage above *V*_{*DD*} and plate line 14 is raised to, for example, *V*_{*DD*}*,* resulting in IGFET 11 being turned on and ferroelectric capacitor 12 being coupled to plate line 14 through IGFET 11. The voltage across ferroelectric capacitor 12 is *V*_{*DD*}. Ferroelectric capacitor 12 changes to saturation state 28, as shown in FIG. 2, regardless of its initial polarization state. Grounding plate line 14 results in a zero voltage across ferroelectric capacitor 12. Ferroelectric capacitor 12 changes from saturation state 28 to logical "zero" polarization state 24. Grounding word line 13 turns off IGFET 11 and isolates ferroelectric capacitor 12 from plate line 14. Thus, ferroelectric capacitor 12 remains in logical "zero" polarization state 24 and a logical "zero" is stored without degradation.

By now, it should be appreciated that a ferroelectric nonvolatile memory cell and a method for restoring data in the memory cell without using techniques such as word line boosting have been provided. The memory cell uses less area, and therefore has a higher packing density, compared with a CMOS pass gate memory cell. Yet, the word line voltage does not need to be boosted to restore data without degradation. Therefore, an energy efficient alternative to prior art nonvolatile memory cells has been provided.

## Claims

1. A data storage element (10) having a word line (13), a bit line (16), and a plate line (14), comprising:
a switch (11) having a control terminal, a first current conducting terminal, and a second current conducting terminal, wherein the control terminal is coupled to the word line (13) and the second current conducting terminal is coupled to the plate line (14); and
a capacitor (12) with polarization retention having first and second terminals, wherein the first terminal is coupled to the bit line (16) and the second terminal is coupled to the first current conducting terminal of the switch (11).

2. The data storage element (10) of claim 1, wherein the switch (11) comprises a field effect transistor.

3. The data storage element (10) of claim 1, wherein the capacitor (12) with polarization retention is a ferroelectric capacitor.

4. A method for restoring data in a data storage element (10), comprising a data storage element (10) according to one of the preceding claims, said method comprising:
providing data in the data storage element (10);
applying a first control signal to the word line (13);
applying a first extraction signal to the plate line (14) to read data from said capacitor (12) with polarization retention;
applying a data restoring voltage to the bit line (16);
applying a second extraction signal to the plate line (14); and
applying a second control signal to the word line (13) after the second extraction signal is applied to the plate line (14), resulting in the data being restored in the data storage element (10).

5. The method for restoring data in a data storage element (10) as claimed in claim 4, wherein the step of applying a data restoring voltage includes applying a voltage determined by the data read from the capacitor (12) with polarization retention.

6. The method for restoring data in a data storage element (10) as claimed in claim 7, wherein the step of providing data in the data storage element (10) comprises the steps of:
applying a data storing voltage to the bit line (16);
turning on the switch (11);
applying the second extraction signal to the plate line (14); and
turning off the switch (11), resulting in data being stored in the data storage element (10).

7. The method for restoring data in a data storage element (10) as claimed in claim 6, wherein the step of applying a data storing voltage includes applying a voltage determined by the data to be provided in the data storage element (10).

## Patentansprüche

1. Datenspeicherelement (10) mit einer Wortleitung (13), einer Bitleitung (16) und einer Plattenleitung (14), mit:
- einem Schalter (11) mit einem Steuerungsanschluss, einem ersten stromleitenden Anschluss und einem zweiten stromleitenden Anschluss, wobei der Steuerungsanschluss mit der Wortleitung (13) gekoppelt ist und der zweite stromleitende Anschluss mit der Plattenleitung (14) gekoppelt ist; und
- einem Kondensator (12) mit Aufrechterhaltung der Polarisation mit einem ersten und einem zweiten Anschluss, wobei der erste Anschluss mit der Bitleitung (16) gekoppelt ist und der zweite Anschluss mit dem ersten stromleitenden Anschluss des Schalters (11) gekoppelt ist.

2. Datenspeicherelement (10) nach Anspruch 1, bei dem der Schalter (11) einen Feldeffekttransistor umfasst.

3. Datenspeicherelement (10) nach Anspruch 1, bei dem der Kondensator (12) mit Aufrechterhaltung der Polarisation ein ferroelektrischer Kondensator ist.

4. Verfahren zum Wiederherstellen von Daten in einem Datenspeicherelement (10), mit einem Datenspeicherelement (10) gemäß einem der vorangehenden Ansprüche, wobei das Verfahren umfasst:
- Bereitstellen von Daten in dem Datenspeicherelement (10);
- Zuführen eines ersten Steuerungssignals zu der Wortleitung (13);
- Zuführen eines ersten Extraktionssignals zu der Plattenleitung (14) zum Lesen von Daten von dem Kondensator (12) mit Aufrechterhaltung der Polarisation;
- Zuführen einer Datenwiederherstellungsspannung zu der Bitleitung (16);
- Zuführen eines zweiten Extraktionssignals zu der Plattenleitung (14); und
- Zuführen eines zweiten Steuerungssignals zu der Wortleitung (13) nachdem das zweite Extraktionssignal zu der Plattenleitung (14) zugeführt ist, mit dem Ergebnis, dass Daten in dem Datenspeicherelement (10) wiederhergestellt werden.

5. Verfahren zum Speichern von Daten in einem Datenspeicherelement (10) nach Anspruch 4, bei dem der Schritt des Zuführens einer Datenwiederherstellungsspannung das Zuführen einer Spannung enthält, die durch die Daten bestimmt ist, die von dem Kondensator (12) mit Aufrechterhaltung der Polarisation gelesen werden.

6. Verfahren zum Wiederherstellen von Daten in einem Datenspeicherelement (10) nach Anspruch 4, bei dem der Schritt des Bereitstellens von Daten in dem Datenspeicherelement (10) die Schritte umfasst:
- Zuführen einer Datenspeicherspannung zu der Bitleitung (16);
- Einschalten des Schalters (11);
- Zuführen des zweiten Extraktionssignals zu der Plattenleitung (14); und
- Ausschalten des Schalters (11), was dazu führt, dass Daten in dem Datenspeicherelement (10) gespeichert werden.

7. Verfahren zum Wiederherstellen von Daten in einem Datenspeicherelement (10) nach Anspruch 6, bei dem der Schritt des Zuführens einer Datenspeicherungsspannung das Zuführen einer Spannung enthält, die von den Daten bestimmt wird, welche in dem Datenspeicherelement (10) bereitzustellen sind.

## Revendications

1. Elément de stockage de données (10) comportant une ligne de mot (13), une ligne de bit (16) et une ligne de plaque (14), comprenant :
un commutateur (11) comportant une borne de commande, une première borne de conduction de courant et une seconde borne de conduction de courant, où la borne de commande est couplée à la ligne de mot (13) et la seconde borne de conduction de courant est couplée à la ligne de plaque (14) ; et
un condensateur (12) avec rétention de polarisation comportant des première et seconde bornes, où la première borne est couplée à la ligne de bit (16) et la seconde borne est couplée à la première borne de conduction de courant du commutateur (11).

2. Elément de stockage de données (10) selon la revendication 1, dans lequel le commutateur (11) comprend un transistor à effet de champ.

3. Elément de stockage de données (10) selon la revendication 1, dans lequel le condensateur (12) avec rétention de polarisation est un condensateur ferro-électrique.

4. Procédé pour restaurer des données dans un élément de stockage de données (10) comprenant un élément de stockage de données (10) selon l'une quelconque des revendications précédentes, ledit procédé comprenant :
la constitution de données dans l'élément de stockage de données (10) ;
l'application d'un premier signal de commande sur la ligne de mot (13) ;
l'application d'un premier signal d'extraction sur la ligne de plaque (14) afin de lire des données à partir dudit condensateur (12) avec rétention de polarisation ;
l'application d'une tension de restauration de données sur la ligne de bit (16) ;
l'application d'un second signal d'extraction sur la ligne de plaque (14); et
l'application d'un second signal de commande sur la ligne de mot (13) après que le second signal d'extraction est appliqué sur la ligne de plaque (14), ce qui conduit au fait que les données sont restaurées dans l'élément de stockage de données (10).

5. Procédé pour restaurer des données dans un élément de stockage de données (10) selon la revendication 4, dans lequel l'étape d'application d'une tension de restauration de données inclut l'application d'une tension qui est déterminée par les données qui sont lues à partir du condensateur (12) avec rétention de polarisation.

6. Procédé pour restaurer des données dans un élément de stockage de données (10) selon la revendication 4, dans lequel l'étape de constitution de données dans l'élément de stockage de données (10) comprend les étapes de :
application d'une tension de stockage de données sur la ligne de bit (16) ;
activation du commutateur (11) ;
application du second signal d'extraction sur la ligne de plaque (14); et
désactivation du commutateur (11), ce qui conduit au fait que les données sont restaurées dans l'élément de stockage de données (10).

7. Procédé pour restaurer des données dans un élément de stockage de données (10) selon la revendication 6, dans lequel l'étape d'application d'une tension de stockage de données inclut l'application d'une tension qui est déterminée par les données destinées à être constituées dans l'élément de stockage de données (10).
